# FASCICULE DE BREVET EUROPEEN

(11) **EP 3 229 033 B1**
(45) Date de publication et mention de la délivrance du brevet: **23.10.2024**
(21) Numéro de dépôt: 16164352.3
(22) Date de dépôt: 08.04.2016
(51) Int. Cl.: G01R 31/327, H01R 9/26, G01R 1/04, G01R 22/06, H01R 13/66, G01R 31/319, G01R 35/00, G01R 35/04

(54) **BLOC D ESSAI DOTÉ DE PRISES D ENTRÉE ET DE SORTIE DE TYPE RJ45**
PRÜFSTAND, DER MIT EIN- UND AUSGANGSSTECKDOSEN VOM TYP RJ45 AUSGESTATTET IST
TEST BLOCK PROVIDED WITH RJ45 INPUT AND OUTPUT PORTS

(43) Date de publication de la demande: 11.10.2017
(73) Titulaire: TE Connectivity Solutions GmbH, 8200 Schaffhausen (CH)
(72) Inventeur: FRANCE, Philippe, 42140 CHAZELLES SUR LYON (FR); CHAILLET, Alexandre, 69009 LYON (FR)
(74) Mandataire: Germain Maureau

(56) Documents cités:
- EP-A2- 1 764 618
- US-A1- 2012 128 078
- US-A1- 2014 273 657
- US-A1- 2015 056 864
- US-A1- 2015 213 291
- ABB FRANCE: "Gamme ESSAILEC - Blocs d'essais", 1 June 2014 (2014-06-01), Montluel, France, pages 1 - 24, XP055302677, Retrieved from the Internet <URL:https://library.e.abb.com/public/fc60562678a8db7ec1257cc400336fad/1SNC169001C0311_Gamme ESSAILECBlocs dessais.pdf> [retrieved on 20160914]

## Description

La présente invention concerne un bloc d'essai destiné à être implanté dans le circuit raccordant un appareil à tester, notamment un compteur ou un relais de protection, et une source d'alimentation, notamment un capteur d'intensité et/ou un capteur de tension, alimentant l'appareil à tester, le bloc d'essai comprenant d'une part une embase comportant une pluralité de circuits électriques internes aptes à permettre la transmission d'informations de la source d'alimentation vers l'appareil à tester, d'autre part un couvercle de protection destiné à être assemblé avec l'embase de manière démontable pour former une enceinte fermée dans laquelle les circuits électriques internes sont logés, l'embase et le couvercle de protection étant configurés de sorte que le retrait du couvercle de protection donne accès à un emplacement d'accueil délimité par l'embase et apte à accueillir par enfichage une fiche de test indépendante du bloc d'essai et reliée électriquement à un équipement de test, notamment un voltmètre et/ou un ampèremètre et/ou une source fictive de courant.

Depuis plusieurs décennies, il est connu d'implanter un appareil électrique connu sous le nom « bloc d'essai » ou « connecteur de test » dans le circuit électrique qui raccorde un appareil à tester à la source d'alimentation qui alimente l'appareil à tester. A titre d'exemple, la Demanderesse commercialise des blocs d'essai de cette nature sous la dénomination commerciale « Essailec ».

Voir, par exemple, le document https://library.e.abb.com/public/ fc60562678a8db7ec1257cc400336fad/1SNC169001C0311_Gamme ESSAILECBIocs dessais.pdf

Usuellement, la source d'alimentation peut comprendre un capteur de tension et/ou un capteur d'intensité associés à une phase déterminée d'un réseau électrique tandis que l'appareil à tester peut être un compteur ou un relais de protection destiné à piloter au moins un disjoncteur susceptible d'agir sur ladite phase en cas de surtension et/ou de surintensité détectées par la source d'alimentation et par le relais de protection.

Classiquement, le bloc d'essai comprend une embase et un couvercle de protection assemblé sur l'embase de manière amovible pour délimiter une enceinte fermée et étanche selon la norme IP40 lorsque le couvercle est fixé sur l'embase. L'enceinte renferme et protège une pluralité de circuits électriques internes indépendants les uns des autres.

Sur une face arrière et/ou sur une face latérale de l'embase, le bloc d'essai comprend une pluralité de prises d'entrée permettant de relier les circuits électriques internes à la source d'alimentation : chaque prise d'entrée est reliée à un unique circuit électrique interne déterminé et chaque circuit électrique interne est relié à une unique prise d'entrée. Il est nécessaire de connecter une pluralité de connecteurs dans les prises d'entrée et eux-mêmes reliés à la source d'alimentation par un câble comprenant une pluralité de brins conducteurs indépendants.

Le bloc d'essai comprend également une pluralité de prises de sortie aménagées sur la face arrière et/ou sur une face latérale de l'embase. Ces prises de sortie permettent de relier les circuits électriques internes à l'appareil à tester selon une organisation dans laquelle chaque prise de sortie est reliée à un unique circuit électrique interne et chaque circuit électrique interne est relié à une unique prise de sortie. Il est nécessaire de connecter une pluralité de connecteurs dans les prises de sortie et eux-mêmes reliés à l'appareil à tester par un câble comprenant une pluralité de brins conducteurs indépendants.

Le retrait du couvercle de protection, du côté de la face avant de l'embase, donne accès à un emplacement d'accueil délimité par l'embase et apte à accueillir, par enfichage, une fiche de test indépendante du bloc d'essai et reliée électriquement à un équipement de test. Usuellement, l'équipement de test peut comprendre un voltmètre et/ou un ampèremètre et/ou une source fictive de courant. L'enfichage de la fiche de test a pour effet d'agir temporairement sur l'état et/ou la configuration de tout ou partie des circuits électriques internes d'une manière prédéterminée, dépendant directement de la conception de la fiche de test, permettant de réaliser des opérations de mesure ou d'étalonnage relativement à l'appareil à tester par l'intermédiaire de l'équipement de test. La fiche de test comprend des éléments d'actionnement configurés à cet effet aptes à agir sur tout ou partie des circuits électriques internes de manière idoine en fonction de l'opération à réaliser.

Si les solutions actuellement implémentées donnent satisfaction en termes d'efficacité et de robustesse, elles ne donnent pas une entière satisfaction malgré tout.

D'abord, il est nécessaire de raccorder chacune des prises d'entrée à la source d'alimentation et de raccorder chacune des prises de sortie à l'appareil à tester. Ces opérations sont par pratiques et éventuellement source d'erreur.

Par ailleurs, la multiplication des moyens de connectique, entre les multiples prises d'entrée et de sortie et autant de connecteurs associés, rend l'ensemble complexe techniquement et perfectible en terme de coût. Il en résulte également une augmentation du facteur de pannes possibles ou de faux contacts qui dépend directement du nombre de pièces utilisées.

La présente invention vise à résoudre tout ou partie des inconvénients listés ci-dessus.

Dans ce contexte, il existe un besoin de fournir un bloc d'essai qui soit simple, robuste, facile et pratique à utiliser et économique.

A cet effet, il est proposé un bloc d'essai selon la revendication 1, destiné à être implanté dans le circuit raccordant un appareil à tester tel qu'un compteur ou un relais de protection et une source d'alimentation alimentant l'appareil à tester telle qu'un capteur d'intensité et/ou un capteur de tension, le bloc d'essai comprenant :
- une embase comportant une pluralité de circuits électriques internes aptes à permettre la transmission d'informations de la source d'alimentation vers l'appareil à tester,
- un couvercle de protection destiné à être assemblé avec l'embase de manière démontable pour former une enceinte fermée dans laquelle les circuits électriques internes sont logés,
- l'embase et le couvercle de protection étant configurés de sorte que le retrait du couvercle de protection donne accès à un emplacement d'accueil délimité par l'embase et apte à accueillir par enfichage une fiche de test indépendante du bloc d'essai et reliée électriquement à un équipement de test, notamment un voltmètre et/ou un ampèremètre et/ou une source fictive de courant,
l'embase comprenant :
- au moins une prise d'entrée de type multi-contact accessible depuis l'extérieur de l'enceinte et dont des contacts sont respectivement reliés électriquement aux circuits électriques internes de manière que la prise d'entrée est connectée à tous les circuits électriques internes en même temps, la prise d'entrée étant configurée de sorte à pouvoir être connectée à un premier connecteur de type multi-contact indépendant du bloc d'essai et dont des contacts sont reliés électriquement à la source d'alimentation, notamment via un câble multiconducteur,
- et au moins une prise de sortie de type multi-contact accessible depuis l'extérieur de l'enceinte et dont des contacts sont respectivement reliés électriquement aux circuits électriques internes de manière que la prise de sortie est connectée à tous les circuits électriques internes en même temps, la prise de sortie étant configurée de sorte à pouvoir être connectée à un deuxième connecteur de type multi-contact indépendant du bloc d'essai et dont des contacts sont reliés électriquement à l'appareil à tester, notamment via un câble multiconducteur.

L'embase et le couvercle de protection comprennent des éléments électriquement conducteurs reliés entre eux et configurés de sorte assurer une continuité et une fermeture de blindage magnétique telles que l'enceinte délimitée par l'embase et le couvercle de protection est une cage de Faraday protégeant les circuits électriques internes par rapport aux champs magnétiques extérieurs à l'enceinte délimitée par l'embase et le couvercle de protection.

L'embase comprend un capot amovible dont le retrait par rapport au reste de l'embase donne un accès aux circuits électriques internes et dont la nature et/ou la forme est adaptée à la nature des prises d'entrée et de sortie.

Il est également proposé un appareillage d'essai comprenant un tel bloc d'essai et une fiche de test apte à s'enficher dans l'emplacement d'accueil délimité par l'embase après le retrait du couvercle de protection, les circuits électriques internes du bloc d'essai et la fiche de test étant configurés de sorte que l'enfichage de la fiche de test provoque une action temporaire sur tout ou partie des circuits électriques internes du bloc d'essai tant que la fiche de test est enfichée, ladite action temporaire étant telle qu'elle permet de réaliser des opérations de mesure et/ou d'étalonnage vis-à-vis de l'appareil à tester grâce à l'équipement de test.

Selon un mode de réalisation particulier, l'appareillage d'essai comprend un premier connecteur de type multi-contact indépendant du bloc d'essai et de la fiche de test, complémentaire de la prise d'entrée du bloc d'essai de sorte à pouvoir être connecté à la prise d'entrée du bloc d'essai et dont des contacts sont reliés électriquement à la source d'alimentation, notamment via un câble multiconducteur et la prise d'entrée du bloc d'essai et le premier connecteur sont configurés de sorte que la connexion électrique entre les circuits électriques internes du bloc d'essai et la source d'alimentation résulte de l'action de connexion du premier connecteur avec la prise d'entrée du bloc d'essai.

L'appareillage d'essai comprend de préférence un deuxième connecteur de type multi-contact indépendant du bloc d'essai et de la fiche de test, complémentaire de la prise de sortie du bloc d'essai de sorte à pouvoir être connecté à la prise de sortie du bloc d'essai et dont des contacts sont reliés électriquement à l'appareil à tester, notamment via un câble multiconducteur et la prise de sortie du bloc d'essai et le deuxième connecteur sont configurés de sorte que la connexion électrique entre les circuits électriques internes et l'appareil à tester résulte de l'action de connexion du deuxième connecteur avec la prise de sortie du bloc d'essai.

De préférence, la fiche de test comprend d'une part une pluralité d'éléments d'actionnement et une pluralité de conducteurs électriques configurés de sorte à agir sur les circuits électriques internes de l'embase d'une manière provoquant ladite action temporaire tant que la fiche de test est enfichée dans l'emplacement d'accueil délimité par l'embase et d'autre part une prise de sortie de type multi-contact dont des contacts sont respectivement connectés à tout ou partie des conducteurs électriques de la fiche de test, la prise de sortie de la fiche de test étant configurée de sorte à pouvoir être connectée à un troisième connecteur de type multi-contact indépendant du bloc d'essai et de la fiche de test et dont des contacts sont reliés électriquement à l'équipement de test, notamment via un câble multiconducteur.

L'appareillage d'essai peut être configuré de sorte que lorsque la fiche de test est enfichée dans l'emplacement d'accueil délimité par l'embase, les conducteurs électriques qui sont connectés aux contacts de la prise de sortie de la fiche de test sont reliés électriquement à tout ou partie des contacts de la prise de sortie de l'embase du bloc d'essai par l'intermédiaire de tout ou partie des circuits électriques internes.

La prise de sortie de la fiche de test est notamment formée par un connecteur mâle ou femelle de type RJ45 comprenant un brochage à 8 positions de contact, chacune des broches correspondant à un contact de la prise de sortie de la fiche de test.

Selon un mode de réalisation particulier, l'appareillage d'essai comprend le troisième connecteur de type multi-contact indépendant du bloc d'essai et de la fiche de test, complémentaire de la prise de sortie de la fiche de test de sorte à pouvoir être connecté à la prise de sortie de la fiche de test et dont des contacts sont reliés électriquement à l'équipement de test, notamment via un câble multiconducteur et la prise de sortie de la fiche de test et le troisième connecteur sont configurés de sorte que la connexion électrique des conducteurs électriques de la fiche de test à l'équipement de test résulte de l'action de connexion du troisième connecteur dans la prise de sortie de la fiche de test.

L'invention sera bien comprise à l'aide de la description qui suit de modes particuliers de réalisation de l'invention donnés à titre d'exemples non limitatifs et représentés sur les dessins annexés, dans lesquels :
Les Figures 1 à 3 sont des vues en perspective d'un exemple d'appareillage d'essai selon l'invention, respectivement sensiblement de dessus, de face et sensiblement de dessous.
La Figure 4 est une vue en éclaté de l'embase du bloc d'essai des Figures 1 à 3.
La Figure 5 est une vue en éclaté de la fiche de test visibles sur les Figures 1 à 3.

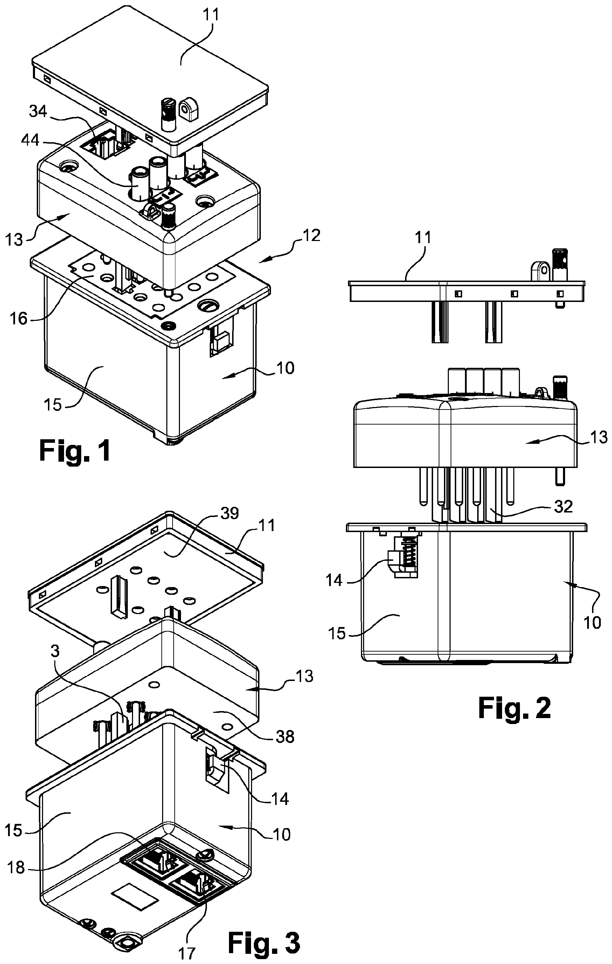

En référence aux Figures 1 à 5 annexées telles que présentées sommairement ci-dessus, l'invention concerne essentiellement un bloc d'essai destiné à être implanté dans le circuit raccordant un appareil à tester (non représenté) et une source d'alimentation (non représentée) alimentant l'appareil à tester.

La source d'alimentation peut comprendre un capteur de tension et/ou un capteur d'intensité associés à une phase déterminée d'un réseau électrique tandis que l'appareil à tester peut être un compteur ou un relais de protection destiné à piloter au moins un disjoncteur susceptible d'agir sur cette phase en cas de surtension et/ou de surintensité détectées par la source d'alimentation et par le relais de protection.

Le bloc d'essai comprend une embase 10 comportant une pluralité de circuits électriques internes indépendants les uns des autres et permettant la transmission d'informations de la source d'alimentation vers l'appareil à tester.

Les circuits électriques internes sont destinés à véhiculer des informations distinctes d'un circuit électrique interne à l'autre et représentatives, au niveau de chaque circuit électrique interne, d'une grandeur physique correspondante issue de la source d'alimentation et à transmettre à l'appareil à tester lorsque les circuits électriques internes sont fermés. La nature et l'organisation des circuits électriques internes peuvent être quelconques et ne sont pas limitatives en soi. Un exemple de réalisation particulier mais en aucun cas limitatif sera décrit plus loin.

Par exemple, il est possible de prévoir que deux circuits électriques internes permettent la transmission de la valeur mesurée de la tension électrique d'une phase d'un réseau électrique lorsque la source d'alimentation comprend un capteur de tension associé à cette phase, jusqu'à un relais de protection lorsque l'appareil à tester comprend un tel relais de protection, susceptible d'actionner un disjoncteur placé sur cette phase en cas de surtension. Toujours à titre d'exemple, il est possible de prévoir que deux autres circuits électriques internes permettent la transmission de la valeur mesurée de l'intensité électrique d'une phase du réseau électrique lorsque la source d'alimentation comprend un capteur d'intensité associé à cette phase, jusqu'à un relais de protection lorsque l'appareil à tester comprend un tel relais de protection, susceptible d'actionner un disjoncteur placé sur cette phase en cas de surintensité.

Le bloc d'essai comprend aussi un couvercle de protection 11 destiné à être assemblé avec l'embase 10 de manière démontable pour former une enceinte fermée dans laquelle les circuits électriques internes sont logés.

Pour cela, de la manière représentée, l'embase 10 peut comprendre un boitier 15 qui délimite une cavité ouverte dans laquelle les circuits électriques internes sont implantés et le couvercle de protection 11 ferme de manière étanche cette cavité lorsqu'il est monté sur l'embase 10, en particulier sur le boitier 15.

Il peut avantageusement être fait en sorte que l'enceinte délimitée par l'embase 10 et le couvercle de protection 11 soit étanche. L'étanchéité de l'enceinte conférée par l'embase 10 et le couvercle de protection 11 respecte notamment la norme IP40 lorsque le couvercle 11 est fixé sur l'embase 10. L'embase 10 et le couvercle de protection 11 comprennent tous les moyens nécessaires pour assurer cette fonction.

L'embase 10 et le couvercle de protection 11 sont configurés de sorte que le retrait du couvercle de protection 11 donne accès à un emplacement d'accueil 12 délimité par l'embase 10 et apte à accueillir, par enfichage, une fiche de test 13 indépendante du bloc d'essai et reliée électriquement à un équipement de test (non représenté). En fonction de la nature du test à réaliser, l'équipement de test peut comprendre un voltmètre et/ou un ampèremètre et/ou une source fictive de courant.

Sur les Figures 1 à 3, il est bien compris que soit le couvercle de protection 11 est fixé sur l'embase 10, soit la fiche de test 13 est fixée sur l'embase 10, mais le couvercle de protection 11 n'a pas pour vocation à être fixé sur la fiche de test 13.

L'invention concerne également un appareillage d'essai comprenant un tel bloc d'essai mais également la fiche de test 13 qui est apte à s'enficher dans l'emplacement d'accueil 12 délimité par l'embase 10 après le retrait du couvercle de protection 11.

L'embase 10 est destinée à être fixée sur une armoire électrique. Le couverle de protection 11 définit une face avant du bloc d'essai lorsqu'il est monté sur l'embase 10 en ce sens qu'il est accessible depuis l'extérieur de l'armoire électrique lorsque le bloc d'essai est monté sur l'armoire électrique. L'embase 10 du bloc d'essai comprend des éléments de montage 14 permettant de fixer le bloc d'essai sur l'armoire métallique, par exemple, comme cela est représenté, une pluralité de pattes de retenue dont chacune peut être serrée par une vis dédiée à cette opération.

La face avant de l'embase 10, lorsque le couvercle de protection 11 est retiré, est constituée par un couvercle avant 16 muni d'une pluralité de rangées de trous traversants. Le couvercle avant 16 est fixé sur le boitier 15 par tout moyen adapté, notamment de type par encliquetage.

L'embase 10 du bloc d'essai comprend au moins une prise d'entrée 17 de type multi-contact accessible depuis l'extérieur de l'enceinte et dont des contacts sont respectivement reliés électriquement aux circuits électriques internes de manière que la prise d'entrée 17 est connectée à tous les circuits électriques internes en même temps. La prise d'entrée 17 est configurée de sorte à pouvoir être connectée à un premier connecteur (non représenté) de type multi-contact indépendant du bloc d'essai et dont des contacts sont reliés électriquement à la source d'alimentation, notamment via un premier câble multiconducteur (non représenté).

L'embase 10 du bloc d'essai comprend également au moins une prise de sortie 18 de type multi-contact accessible depuis l'extérieur de l'enceinte et dont des contacts sont respectivement reliés électriquement aux circuits électriques internes de manière que la prise de sortie 18 est connectée à tous les circuits électriques internes en même temps. La prise de sortie 18 est configurée de sorte à pouvoir être connectée à un deuxième connecteur (non représenté) de type multi-contact indépendant du bloc d'essai et dont des contacts sont reliés électriquement à l'appareil à tester, notamment via un deuxième câble multiconducteur (non représenté).

Pour la prise d'entrée 17 et pour la prise de sortie 18, chaque contact de la prise considérée est relié à un seul circuit électrique interne et chaque circuit électrique interne est relié à un seul contact de cette prise. Ainsi, chaque circuit électrique interne du bloc d'essai est apte à relier électriquement, lorsque ce circuit électrique interne est fermé, un unique contact de la prise d'entrée 17 à un unique contact de la prise de sortie 18.

La connexion électrique entre les contacts des prises d'entrée 17 et de sortie 18 avec les circuits électriques internes du bloc d'essai peut se faire au niveau d'un circuit imprimé 19, connu sous l'acronyme « PCB » pour « Printed Circuit Board » en terminologie anglo-saxonne. La nature du circuit imprimé 19 dépend notamment de la nature des prises 17, 18 et de la nature des circuits électriques internes.

Dans ce document, le terme « multiconducteur » signifie notamment que le câble concerné comprend une pluralité de conducteurs électriques isolés individuellement, et donc isolés les uns des autres. Le terme « multi-contact » signifie que la prise 17, 18 ou le connecteur avec qui la prise 17, 18 coopère comprend une pluralité de contacts électriques isolés individuellement, et donc isolés les uns des autres.

Selon un mode de réalisation particulier donnant une entière satisfaction, la prise d'entrée 17 et la prise de sortie 18 sont chacune formées par un connecteur mâle ou femelle de type RJ45, dont un autre nom usuel est 8P8C (8 positions et 8 contacts électriques), comprenant un brochage à 8 positions de contact, chacune des broches correspondant à un contact de la prise 17, 18 concernée.

Cette caractéristique, bien qu'avantageuse et efficace, n'est pas limitative. Les moyens utilisés pour parvenir à la fonction présentée ci-dessus pour les prises 17, 18 peuvent être quelconques. Il est par exemple possible de prévoir que la prise d'entrée 17 et la prise de sortie 18 soient chacune formées par un connecteur mâle ou femelle de type USB pour « Universal Serial Bus » en terminologie anglo-saxonne.

L'embase 10 et le couvercle de protection 11 comprennent également des éléments électriquement conducteurs reliés entre eux et configurés de sorte assurer une continuité et une fermeture de blindage magnétique telles que l'enceinte délimitée par l'embase 10 et le couvercle de protection 11 est une cage de Faraday protégeant les circuits électriques internes vis-à-vis des champs magnétiques extérieurs à l'enceinte délimitée par l'embase 10 et le couvercle de protection 11.

L'embase 10 comprend un capot amovible 20 dont le retrait par rapport au reste de l'embase 10 donne un accès aux circuits électriques internes et dont la nature et/ou la forme est adaptée à la nature des prises d'entrée et de sortie 17, 18. La fixation du capot amovible 20 avec le boitier 15 peut se faire par exemple par l'intermédiaire de vis 21. Un autre avantage est de pouvoir adapter le capot amovible 20 en fonction de la nature des prises d'entrée et de sortie 17, 18 et du circuit imprimé 19 tout en utilisant un boitier 15 commun aux différentes variantes d'embases 10 ainsi obtenues par remplacement ou substitution des prises d'entrée et de sortie 17, 18, du capot amovible 20 et du circuit imprimé 19.

Le capot amovible 20 comprend donc une partie des éléments électriquement conducteurs constitutifs de la cage de Faraday. Il en est de même pour le boitier 15 et pour le couvercle de protection 11.

Le capot amovible 20 vient se fixer sur le boitier 15 de sorte à définir la face arrière de l'embase 10, c'est-à-dire la face opposée à la face avant recevant le couvercle de protection 11 et destinée à être tournée vers l'intérieur de l'armoire électrique. Le capot amovible 20 comprend des ouvertures permettant à la prise d'entrée 17 et à la prise de sortie 18 d'être accessible depuis l'extérieur du bloc d'essai du côté de la face arrière de l'embase 10. Il reste toutefois possible d'envisager que la prise d'entrée 17 et/ou la prise de sortie 18 puisse déboucher vers l'extérieur de l'embase 10 au niveau d'une face latérale de l'embase 10, c'est-à-dire une face latérale du boitier 15 qui rejoint le capot amovible 20 au couvercle de protection 11.

Par ailleurs, le bloc d'essai comprend des éléments électriquement conducteurs (non représentés) reliant les éléments électriquement conducteurs constitutifs de la cage de Faraday à l'armoire métallique lorsque l'embase 10 est montée sur l'armoire électrique via les éléments de montage 14. Ainsi, la cage de Faraday est électriquement reliée au métal de l'armoire métallique.

Selon un mode de réalisation particulier, sur tout ou partie de la surface des parois extérieures de l'embase 10, ces parois extérieures sont recouvertes intérieurement et/ou extérieurement, ou constituées, par au moins un panneau d'aluminium

A titre d'exemple, les parois extérieures de l'embase 10 sont recouvertes extérieurement ou constituées par de l'aluminium formant un panneau continu fermé. Par exemple, il est possible de prévoir que 5 des 6 parois du boitier 15 soient recouvertes d'aluminium de façon que le capot vienne fermer le parallélépipède d'aluminium de la cage de Faraday.

En particulier, sur tout ou partie de la surface des parois extérieures du capot amovible 20, ces parois extérieures sont recouvertes intérieurement et/ou extérieurement, ou constituées, par au moins un panneau d'aluminium.

A titre d'exemple, les parois extérieures du capot 20 sont recouvertes extérieurement ou constituées par de l'aluminium formant un panneau continu fermé. Notamment, la face extérieure et/ou la face intérieure de la paroi principale extérieure du capot amovible sont recouvertes d'aluminium, en sachant que les 4 faces de la tranche sont également avec de l'aluminium.

Parallèlement, sur tout ou partie de la surface des parois extérieures du couvercle de protection 11, ces parois extérieures sont recouvertes intérieurement et/ou extérieurement, ou constituées, par au moins un panneau d'aluminium.

A titre d'exemple, les parois extérieures du couvercle de protection 11 sont recouvertes intérieurement par un panneau d'aluminium monobloc 39 (visible sur la Figure 3) venant en regard du couvercle avant 16 lorsque le couvercle de protection 11 est fixé sur l'embase 10.

Il est compris que les panneaux d'aluminium présents au niveau de l'embase 10 et au niveau du capot de protection 11 sont tous raccordés entre eux de sorte à former la cage de Faraday.

Les circuits électriques internes du bloc d'essai et la fiche de test 13 sont configurés de sorte que l'enfichage de la fiche de test 13 provoque une action temporaire sur tout ou partie des circuits électriques internes du bloc d'essai tant que la fiche de test 13 est enfichée, cette action temporaire étant telle qu'elle permet de réaliser des opérations de mesure et/ou d'étalonnage vis-à-vis de l'appareil à tester grâce à l'équipement de test.

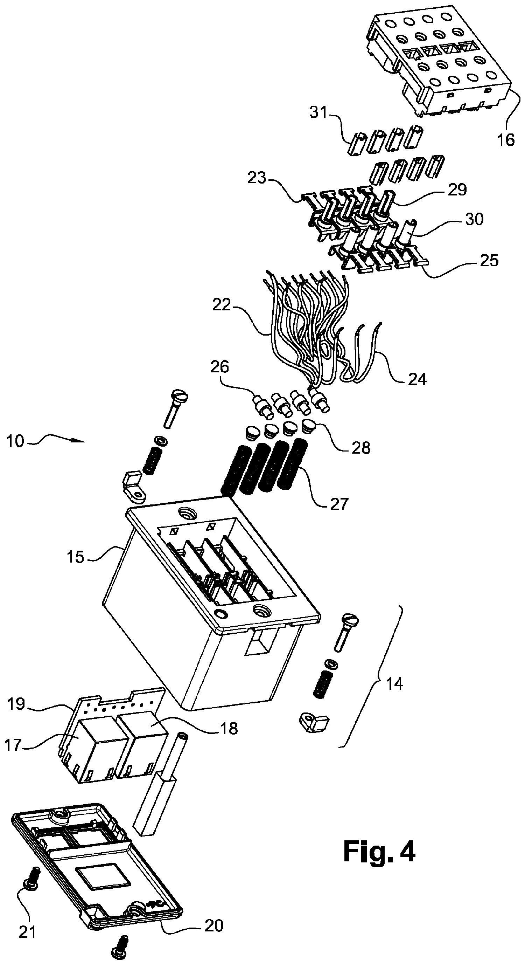

Selon un mode de réalisation tel que représenté sur la Figure 4, efficace mais non limitatif en soi, chaque circuit électrique interne du bloc d'essai comprend un premier conducteur électrique 22 relié électriquement à un contact de la prise d'entrée 17 et à une première barrette de contact 23. Chaque circuit électrique interne comprend également un deuxième conducteur électrique 24 relié électriquement à un contact de la prise de sortie 18 et à une deuxième barrette de contact 25. Les deux barrettes de contact 23, 25 peuvent être connectées électriquement, ou déconnectées, en fonction de la position occupée par un contact mobile 26 adoptant par exemple la forme d'un galet et sollicité par un ressort de pression 27 vers la position conférant le contact entre les deux barrettes 23, 25. L'interface entre le ressort de pression 27 et le contact mobile 26 est réalisée par une pastille 28 montée à l'extrémité mobile du ressort de pression 27 dont l'extrémité fixe vient en contact contre le boitier 15.

Selon ce montage, chaque circuit électrique interne est fermé tant que le contact mobile 26 est en contact des deux barrettes 23, 25 sous l'effet du ressort 27. Ceci correspond à la configuration naturellement occupée tant que la fiche de test 13 n'est pas enfichée dans l'emplacement d'accueil 12 délimité par l'embase 10. Par contre, un déplacement forcé du contact mobile 26 en opposition à l'action du ressort 27 provoque l'ouverture du circuit électrique interne, en ce sens que ce déplacement du contact mobile 26 induit que les deux barrettes de contact 23, 25 ne sont plus en contact électrique direct.

La première barrette de contact 23 comprend un plot de test 29 et la deuxième barrette de contact 25 comprend un plot de test 30, dont le fonctionnement sera expliqué plus loin. Chaque plot de test 29, 30 comprend un ressort de contact 31.

Tous les circuits électrique internes ainsi constitués sont logés dans le boitier 15 de l'embase 10 et le couvercle avant 16 vient recouvrir et protéger les composants des circuits électriques internes.

Le couvercle avant 16 comprend :
- une première rangée de trous traversants, dont chaque trou traversant est situé à l'aplomb de l'une des premières barrettes de contact 23,
- une deuxième rangée de trous traversants, dont chaque trou traversant est situé à l'aplomb de l'un des plots de test 29,
- une troisième rangée de trous traversants, dont chaque trou traversant est situé à l'aplomb de l'un des contacts mobiles 26,
- une quatrième rangée de trous traversants, dont chaque trou traversant est situé à l'aplomb de l'un des plots de test 30,
- et une cinquième rangée de trous traversants, dont chaque trou traversant est situé à l'aplomb de l'une des deuxièmes barrettes de contact 25.

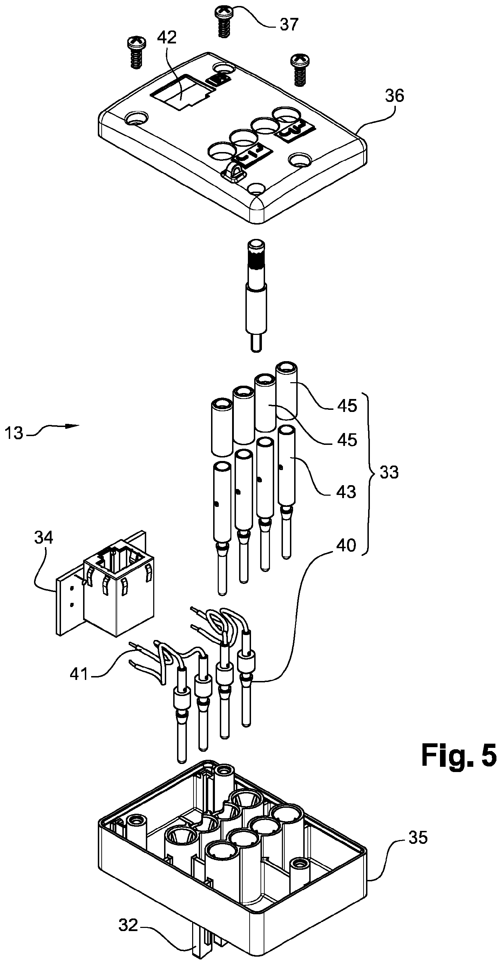

Selon un mode de réalisation particulier et en référence maintenant aux Figures 2 et 5, la fiche de test 13 comprend d'une part une pluralité d'éléments d'actionnement 32 et une pluralité de conducteurs électriques 33 configurés de sorte à agir sur les circuits électriques internes de l'embase 10 d'une manière provoquant l'action temporaire qui a été évoquée précédemment tant que la fiche de test 13 est enfichée dans l'emplacement d'accueil 12 délimité par l'embase 10.

La fiche de test 13 comprend d'autre part une prise de sortie 34 de type multi-contact dont des contacts sont respectivement connectés à tout ou partie des conducteurs électriques 33, la prise de sortie 34 de la fiche de test 13 étant configurée de sorte à pouvoir être connectée à un troisième connecteur (non représenté) de type multi-contact indépendant du bloc d'essai et de la fiche de test 13 et dont des contacts sont reliés électriquement à l'équipement de test, notamment via un troisième câble multiconducteur (non représenté).

Selon un mode de réalisation particulier, la fiche de test 13 comprend un boitier obtenu par la réunion d'un support 35 délimitant une cavité et d'un capot 36 refermant cette cavité. La prise de sortie 34 de la fiche de test 13 est logée dans cette cavité et débouche vers l'extérieur du boitier au travers d'une ouverture 42 ménagée dans le capot 36. Le capot 36 est fixé sur le support 35 par tout moyen mécanique envisageable, comme par exemple par l'intermédiaire d'une pluralité de vis 37. Le capot 36 est situé sur la face avant de la fiche de test 13 dont la face arrière 38 est destinée à venir contre la face avant de l'embase 10 (plus précisément en regard du couvercle avant 16) une fois que le couvercle de protection 11 a été retiré.

Il est précisé ici que les éléments d'actionnement 32 peuvent être constitués par des tiges s'étendant en saillie depuis la face arrière 38 de la fiche de test 13, à l'extérieur du support 35, et aptes à s'insérer chacune dans un trou traversant de la troisième rangée de trous traversants ménagés dans le couvercle avant 16. Leur hauteur est telle que l'insertion totale de ces tiges obtenue au moment de la mise en contact de la face arrière 38 de la fiche de test 13 contre l'embase 10 provoque le déplacement des contacts mobiles 26 en opposition à l'action des ressorts de pression 27 et induit l'ouverture des circuits électriques internes dont le contact mobile 26 a été déplacé.

Comme cela est représenté sur la Figure 5, certains conducteurs électriques 33 de la fiche de test 13 comprennent chacun une broche 40 apte à venir en saillie de la face arrière 38 à l'extérieur du support 35. Chaque broche 40 est apte à s'insérer dans un trou traversant de la quatrième rangée de trous traversants ménagés dans le couvercle avant 16 et à venir s'enficher dans l'un des plots de test 30 et est reliée électriquement à l'un des contacts de la prise de sortie 34 par l'intermédaire d'un fil conducteur 41.

En plus de la prise de sortie 34 de type multicontact, la fiche de test 13 peut également comprendre une pluralité de prises de sortie 44 chacune de type monocontact et les autres conducteurs électriques 33 de la fiche de test 13 comprennent chacun une broche 43 s'étendant en saillie de la face arrière 38 à l'extérieur du support 35. Chaque broche 43 est apte à s'insérer dans un trou traversant de la deuxième rangée de trous traversants ménagés dans le couvercle avant 16 et à venir s'enficher dans l'un des plots de test 29 et est reliée électriquement au contact unique de l'une des prises de sortie 44 monocontact. Un capuchon isolant 45 est rapporté autour d'une partie de la broche 43.

Lorsque la fiche de test 13 est enfichée dans l'emplacement d'accueil 12 délimité par l'embase 10, les conducteurs électriques 33 qui sont connectés aux contacts de la prise de sortie 34 de la fiche de test 13 viennent s'enficher dans les plots de test 30 via les broches 40 et sont alors reliés électriquement à tout ou partie des contacts de la prise de sortie 18 de l'embase 10 du bloc d'essai par l'intermédiaire de tout ou partie des circuits électriques internes, notamment via les deuxièmes barrettes 25 et via les conducteurs électriques 24. Dans le même temps, les conducteurs électriques 33 qui sont connectés aux contacts des prises de sortie 44 de la fiche de test 13 viennent s'enficher dans les plots de test 29 via les broches 43 et sont alors reliés électriquement à tout ou partie des contacts de la prise d'entrée 17 de l'embase 10 du bloc d'essai par l'intermédiaire de tout ou partie des circuits électriques internes, notamment via les les premières barrettes 23 et via les conducteurs électriques 22.

Dans l'exemple illustré, les éléments d'actionnement 32, les conducteurs électriques 33 et l'organisation des circuits électriques internes de l'embase 10 sont organisés de sorte à fonctionner selon un principe de test à contacts courts-circuités. Ainsi, le circuit électrique interne est court-circuité automatiquement à l'enfichage de la fiche de test 13. En fonctionnement normal, l'embase 10 assure la continuité électrique tant que le couvercle de protection 11 est monté sur l'embase 10. Au moment du test, le couvercle 11 est retiré. Au moment de l'enfichage de la fiche de test 13, les broches 40, 43 de la fiche de test 13 viennent d'abord en contact avec les plots de test 29, 30 de l'embase 10 afin d'établir le circuit de test via les conducteurs électriques 33. Ce n'est qu'une fois la fiche de test 13 complètement insérée dans l'embase 10 que le contact mobile 26 ouvre le contact entre les barrettes de contact 23, 25 afin de dériver entièrement le courant via les conducteurs électriques 33. Au moment de la remise en service à l'issue du test, grâce au contact mobile 26 sollicité par le ressort de pression 27, le circuit électrique interne se referme automatiquement quand la fiche de test 13 est déconnectée hors de l'embase 10.

Cette caractéristique n'est toutefois pas limitative et il est possible de prévoir une organisation de la fiche de test 13 et de l'embase 10 telle qu'elles fonctionnent selon un principe de test à contacts ouverts (le circuit électrique interne est ouvert lorsque le couvercle de protection 11 est enlevé et l'appareil à tester n'est alors plus alimenté) ou selon un principe de test à contacts fermés (la connexion électrique étant permanente, le circuit électrique interne reste fermé durant le test).

La prise de sortie de la fiche de test 13 est formée par un connecteur mâle ou femelle de type RJ45 comprenant un brochage à 8 positions de contact, chacune des broches correspondant à un contact de la prise de sortie de la fiche de test.

L'appareillage d'essai comprend le premier connecteur précédemment évoqué, qui est de type multi-contact, indépendant du bloc d'essai et de la fiche de test 13, complémentaire de la prise d'entrée 17 du bloc d'essai de sorte à pouvoir être connecté à la prise d'entrée 17 du bloc d'essai et dont des contacts sont reliés électriquement à la source d'alimentation, notamment via le premier câble multiconducteur. La prise d'entrée 17 du bloc d'essai et le premier connecteur sont configurés de sorte que la connexion électrique entre les circuits électriques internes du bloc d'essai et la source d'alimentation résulte de l'action de connexion du premier connecteur avec la prise d'entrée 17 du bloc d'essai. Le premier connecteur peut notamment être de type RJ45 et présenter une nature complémentaire de celle de la prise d'entrée 17.

Selon un mode de réalisation particulier, les éléments électriquement conducteurs constitutifs de la cage de Faraday sont reliés au blindage du premier câble multiconducteur.

L'appareillage d'essai comprend également le deuxième connecteur précédemment évoqué, qui est de type multi-contact, indépendant du bloc d'essai et de la fiche de test 13, complémentaire de la prise de sortie 18 du bloc d'essai de sorte à pouvoir être connecté à la prise de sortie 18 du bloc d'essai et dont des contacts sont reliés électriquement à l'appareil à tester, notamment via le deuxième câble multiconducteur. La prise de sortie 18 du bloc d'essai et le deuxième connecteur sont configurés de sorte que la connexion électrique entre les circuits électriques internes et l'appareil à tester résulte de l'action de connexion du deuxième connecteur avec la prise de sortie 18 du bloc d'essai. Le deuxième connecteur peut notamment être de type RJ45 et présenter une nature complémentaire de celle de la prise de sortie 18.

Avantageusement, les éléments électriquement conducteurs constitutifs de la cage de Faraday sont reliés au blindage du deuxième câble multiconducteur.

L'appareillage d'essai comprend enfin le troisième connecteur de type multi-contact précédemment évoqué, qui est indépendant du bloc d'essai et de la fiche de test, complémentaire de la prise de sortie 34 de la fiche de test 13 de sorte à pouvoir être connecté à la prise de sortie 34 de la fiche de test 13 et dont des contacts sont reliés électriquement à l'équipement de test, notamment via le troisième câble multiconducteur. La prise de sortie 34 de la fiche de test 13 et le troisième connecteur sont configurés de sorte que la connexion électrique des conducteurs électriques 33 de la fiche de test 13 à l'équipement de test résulte de l'action de connexion du troisième connecteur dans la prise de sortie 34 de la fiche de test 13. Le troisième connecteur peut notamment être de type RJ45 et présenter une nature complémentaire de celle de la prise de sortie 34.

Le bloc d'essai qui vient d'être décrit est simple, robuste, facile et pratique à utiliser et économique. Le nombre de prises est peu élevé et il est nécessaire de manipuler peu de connecteurs électriques, ce qui renforce sa fiabilité en prévoyant un nombre de pièces restreint. Par ailleurs, la fiabilité et la qualité des mesures et des étalonnages sont très bonnes, de même que la sécurité.

## Revendications

1. Bloc d'essai destiné à être implanté dans le circuit raccordant un appareil à tester tel qu'un compteur ou un relais de protection et une source d'alimentation alimentant l'appareil à tester telle qu'un capteur d'intensité et/ou un capteur de tension, le bloc d'essai comprenant :
- une embase (10) comportant une pluralité de circuits électriques internes aptes à permettre la transmission d'informations de la source d'alimentation vers l'appareil à tester,
- un couvercle de protection (11) destiné à être assemblé avec l'embase (10) de manière démontable pour former une enceinte fermée dans laquelle les circuits électriques internes sont logés,
- l'embase (10) et le couvercle de protection (11) étant configurés de sorte que le retrait du couvercle de protection (11) donne accès à un emplacement d'accueil (12) délimité par l'embase (10) et apte à accueillir par enfichage une fiche de test (13) indépendante du bloc d'essai et reliée électriquement à un équipement de test, notamment un voltmètre et/ou un ampèremètre et/ou une source fictive de courant,
l'embase (10) et le couvercle de protection (11) comprenant des éléments électriquement conducteurs reliés entre eux et configurés de sorte à assurer une continuité,
le bloc d'essai étant **caractérisé en ce que** l'embase (10) comprend :
- au moins une prise d'entrée (17) de type multi-contact accessible depuis l'extérieur de l'enceinte et dont des contacts sont respectivement reliés électriquement aux circuits électriques internes de manière que la prise d'entrée (17) est connectée à tous les circuits électriques internes en même temps, la prise d'entrée (17) étant configurée de sorte à pouvoir être connectée à un premier connecteur de type multi-contact indépendant du bloc d'essai et dont des contacts sont reliés électriquement à la source d'alimentation, notamment via un câble multiconducteur,
- et au moins une prise de sortie (18) de type multi-contact accessible depuis l'extérieur de l'enceinte et dont des contacts sont respectivement reliés électriquement aux circuits électriques internes de manière que la prise de sortie (18) est connectée à tous les circuits électriques internes en même temps, la prise de sortie (18) étant configurée de sorte à pouvoir être connectée à un deuxième connecteur de type multi-contact indépendant du bloc d'essai et dont des contacts sont reliés électriquement à l'appareil à tester, notamment via un câble multiconducteur,
**en ce que** l'embase (10) et le couvercle de protection (11) comprennent en outre des éléments électriquement conducteurs reliés entre eux et configurés de sorte à assurer également une fermeture de blindage magnétique telles que l'enceinte délimitée par l'embase (10) et le couvercle de protection (11) est une cage de Faraday protégeant les circuits électriques internes par rapport aux champs magnétiques extérieurs à l'enceinte délimitée par l'embase (10) et le couvercle de protection (11), et
**en ce que** l'embase (10) comprend un capot amovible (20) dont le retrait par rapport au reste de l'embase (10) donne un accès aux circuits électriques internes et dont la nature et/ou la forme est adaptée à la nature des prises d'entrée et de sortie (17, 18).

2. Appareillage d'essai comprenant un bloc d'essai selon la revendication 1 et une fiche de test (13) apte à s'enficher dans l'emplacement d'accueil (12) délimité par l'embase (10) après le retrait du couvercle de protection (11), les circuits électriques internes du bloc d'essai et la fiche de test (13) étant configurés de sorte que l'enfichage de la fiche de test (13) provoque une action temporaire sur tout ou partie des circuits électriques internes du bloc d'essai tant que la fiche de test (13) est enfichée, ladite action temporaire étant telle qu'elle permet de réaliser des opérations de mesure et/ou d'étalonnage vis-à-vis de l'appareil à tester grâce à l'équipement de test.

3. Appareillage d'essai selon la revendication 2, **caractérisé en ce qu'**il comprend un premier connecteur de type multi-contact indépendant du bloc d'essai et de la fiche de test (13), complémentaire de la prise d'entrée du bloc d'essai de sorte à pouvoir être connecté à la prise d'entrée (17) du bloc d'essai et dont des contacts sont reliés électriquement à la source d'alimentation, notamment via un câble multiconducteur et **en ce que** la prise d'entrée (17) du bloc d'essai et le premier connecteur sont configurés de sorte que la connexion électrique entre les circuits électriques internes du bloc d'essai et la source d'alimentation résulte de l'action de connexion du premier connecteur avec la prise d'entrée (17) du bloc d'essai.

4. Appareillage d'essai selon l'une des revendications 2 ou 3, **caractérisé en ce qu'**il comprend un deuxième connecteur de type multi-contact indépendant du bloc d'essai et de la fiche de test (13), complémentaire de la prise de sortie (18) du bloc d'essai de sorte à pouvoir être connecté à la prise de sortie (18) du bloc d'essai et dont des contacts sont reliés électriquement à l'appareil à tester, notamment via un câble multiconducteur et **en ce que** la prise de sortie (18) du bloc d'essai et le deuxième connecteur sont configurés de sorte que la connexion électrique entre les circuits électriques internes et l'appareil à tester résulte de l'action de connexion du deuxième connecteur avec la prise de sortie (18) du bloc d'essai.

5. Appareillage d'essai selon l'une des revendications 2 à 4, **caractérisé en ce que** la fiche de test (13) comprend d'une part une pluralité d'éléments d'actionnement (32) et une pluralité de conducteurs électriques (33) configurés de sorte à agir sur les circuits électriques internes de l'embase (10) d'une manière provoquant ladite action temporaire tant que la fiche de test (13) est enfichée dans l'emplacement d'accueil (12) délimité par l'embase (10) et d'autre part une prise de sortie (34) de type multi-contact dont des contacts sont respectivement connectés à tout ou partie des conducteurs électriques (33) de la fiche de test (13), la prise de sortie (34) de la fiche de test (13) étant configurée de sorte à pouvoir être connectée à un troisième connecteur de type multi-contact indépendant du bloc d'essai et de la fiche de test (13) et dont des contacts sont reliés électriquement à l'équipement de test, notamment via un câble multiconducteur.

6. Appareillage d'essai selon la revendication 5, **caractérisé en ce que** lorsque la fiche de test (13) est enfichée dans l'emplacement d'accueil (12) délimité par l'embase (10), les conducteurs électriques (33) qui sont connectés aux contacts de la prise de sortie (34) de la fiche de test (13) sont reliés électriquement à tout ou partie des contacts de la prise de sortie (18) de l'embase (10) du bloc d'essai par l'intermédiaire de tout ou partie des circuits électriques internes.

7. Appareillage d'essai selon l'une des revendications 5 ou 6, **caractérisé en ce que** la prise de sortie (34) de la fiche de test (13) est formée par un connecteur mâle ou femelle de type RJ45 comprenant un brochage à 8 positions de contact, chacune des broches correspondant à un contact de la prise de sortie (34) de la fiche de test (13).

8. Appareillage d'essai selon l'une des revendications 5 à 7, **caractérisé en ce qu'**il comprend le troisième connecteur de type multi-contact indépendant du bloc d'essai et de la fiche de test (13), complémentaire de la prise de sortie (34) de la fiche de test (13) de sorte à pouvoir être connecté à la prise de sortie (34) de la fiche de test (13) et dont des contacts sont reliés électriquement à l'équipement de test, notamment via un câble multiconducteur et **en ce que** la prise de sortie (34) de la fiche de test (13) et le troisième connecteur sont configurés de sorte que la connexion électrique des conducteurs électriques (33) de la fiche de test (13) à l'équipement de test résulte de l'action de connexion du troisième connecteur dans la prise de sortie (34) de la fiche de test (13).

## Patentansprüche

1. Prüfblock, der dazu bestimmt ist, in die Schaltung eingebaut zu werden, die ein zu testendes Gerät, wie einen Zähler oder ein Schutzrelais, an eine Versorgungsquelle, die das zu testende Gerät versorgt, wie einen Stärkensensor und/oder einen Spannungssensor, anschließt, wobei der Prüfblock umfasst:
- ein Unterteil (10), das eine Vielzahl von internen elektrischen Schaltungen enthält, die in der Lage sind, die Übertragung von Informationen von der Versorgungsquelle zum zu testenden Gerät zu ermöglichen,
- eine Schutzabdeckung (11), die dazu bestimmt ist, mit dem Unterteil (10) demontierbar zusammengebaut zu werden, um ein geschlossenes Gehäuse zu bilden, in dem die internen elektrischen Schaltungen untergebracht sind,
- wobei das Unterteil (10) und die Schutzabdeckung (11) so konfiguriert sind, dass, durch Entfernen der Schutzabdeckung (11), Zugang zu einem Aufnahmeraum (12) erhalten wird, der durch den Unterteil (10) begrenzt ist, und in der Lage ist, durch Einstecken einen Teststecker (13) aufzunehmen, der vom Prüfblock unabhängig ist und elektrisch mit einer Testeinrichtung verbunden ist, insbesondere einem Voltmeter und/oder einem Amperemeter und/oder einer fiktiven Stromquelle,
wobei das Unterteil (10) und die Schutzabdeckung (11) elektrisch leitende Elemente umfassen, die zwischen sich verbunden sind, und so konfiguriert sind, dass Kontinuität gewährleistet ist,
wobei der Prüfblock **dadurch gekennzeichnet ist, dass** das Unterteil (10) umfasst:
- mindestens eine Eingangsbuchse (17) vom Typ Multikontakt, die von außerhalb des Gehäuses zugänglich ist, und deren Kontakte jeweils elektrisch mit den internen elektrischen Schaltungen verbunden sind, so dass die Eingangsbuchse (17) gleichzeitig mit allen internen elektrischen Schaltungen verbunden ist, wobei die Eingangsbuchse (17) so konfiguriert ist, dass sie mit einem ersten Verbinder vom Typ Multikontakt verbunden werden kann, der unabhängig vom Prüfblock ist, und dessen Kontakte elektrisch mit der Versorgungsquelle verbunden sind, insbesondere über ein Mehrleiterkabel,
- und mindestens eine Ausgangsbuchse (18) vom Typ Multikontakt, die von außerhalb des Gehäuses zugänglich ist, und deren Kontakte jeweils elektrisch mit den internen elektrischen Schaltungen verbunden sind, so dass die Ausgangsbuchse (18) gleichzeitig mit allen internen elektrischen Schaltungen verbunden ist, wobei die Ausgangsbuchse (18) so konfiguriert ist, dass sie mit einem zweiten Verbinder vom Typ Multikontakt verbunden werden kann, der unabhängig vom Prüfblock ist, und dessen Kontakte elektrisch mit dem zu testenden Gerät verbunden sind, insbesondere über ein Mehrleiterkabel,
dadurch, dass das Unterteil (10) und die Schutzabdeckung (11) ferner elektrisch leitende Elemente umfassen, die miteinander verbunden sind und so konfiguriert sind, dass sie auch einen magnetischen Abschirmungsverschluss gewährleisten, so dass das Gehäuse, das vom Unterteil (10) und der Schutzabdeckung (11) begrenzt ist, einen Faradayschen Käfig bildet, der die internen elektrischen Schaltung vor Magnetfeldern außerhalb des Gehäuses schützt, das vom Unterteil (10) und der Schutzabdeckung (11) begrenzt ist,
und dadurch, dass das Unterteil (10) eine abnehmbare Abdeckung (20) umfasst, deren Entfernung vom Rest des Unterteils (10) einen Zugang zu den internen elektrischen Schaltungen ermöglicht, und deren Art und/oder Form der Art der Eingangs- und Ausgangsbuchsen (17, 18) angepasst ist.

2. Prüfanlage, einen Prüfblock nach Anspruch 1 umfassend und einen Teststecker (13), der in der Lage ist, in den Aufnahmeraum (12) eingesteckt zu werden, der durch das Unterteil (10) begrenzt ist, nach dem Entfernen der Schutzabdeckung (11), wobei die internen elektrischen Schaltungen des Prüfblocks und der Teststecker (13) so konfiguriert sind, dass das Einstecken des Teststeckers (13) eine vorübergehende Wirkung auf alle oder einen Teil der internen elektrischen Schaltungen des Prüfblocks bewirkt, solange der Teststecker (13) eingesteckt ist, wobei die vorübergehende Wirkung derart ist, dass sie ermöglicht, Mess- und/oder Kalibrierungsvorgänge durch die Testeinrichtung am zu testenden Gerät durchzuführen.

3. Prüfanlage nach Anspruch 2, **dadurch gekennzeichnet, dass** sie einen ersten Verbinder vom Typ Multikontakt umfasst, der unabhängig vom Prüfblock und vom Teststecker (13) ist, und komplementär zur Eingangsbuchse des Prüfblocks, so dass er mit der Eingangsbuchse (17) des Prüfblocks verbunden werden kann und dessen Kontakte elektrisch mit der Versorgungsquelle verbunden sind, insbesondere über ein Mehrleiterkabel, und dadurch, dass die Eingangsbuchse (17) des Prüfblocks und der erste Verbinder so konfiguriert sind, dass die elektrische Verbindung zwischen den internen elektrischen Schaltungen des Prüfblocks und der Versorgungsquelle aus der Maßnahme der Verbindung des ersten Steckverbinders mit der Eingangsbuchse (17) des Prüfblocks resultiert.

4. Prüfanlage nach einem der Ansprüche 2 oder 3, **dadurch gekennzeichnet, dass** sie einen zweiten Verbinder vom Typ Multikontakt umfasst, der unabhängig vom Prüfblock und vom Teststecker (13) ist, und komplementär zur Ausgangsbuchse (18) des Prüfblocks, so dass er mit der Ausgangsbuchse (18) des Prüfblocks verbunden werden kann und dessen Kontakte elektrisch mit dem zu testenden Gerät verbunden sind, insbesondere über ein Mehrleiterkabel, und dadurch, dass die Ausgangsbuchse (18) des Prüfblocks und der zweite Verbinder so konfiguriert sind, dass die elektrische Verbindung zwischen den internen elektrischen Schaltungen und dem zu testenden Gerät aus der Maßnahme der Verbindung des zweiten Steckverbinders mit der Ausgangsbuchse (18) des Prüfblocks resultiert.

5. Prüfanlage nach einem der Ansprüche 2 bis 4, **dadurch gekennzeichnet, dass** der Teststecker (13) einerseits eine Vielzahl von Betätigungselementen (32) und eine Vielzahl von elektrischen Leitern (33) umfasst, die so konfiguriert sind, dass sie auf die internen elektrischen Schaltungen des Unterteils (10) in einer Weise agieren, die die vorübergehende Wirkung bewirkt, solange der Teststecker (13) im Aufnahmeraum (12) eingesteckt ist, der vom Unterteil (10) begrenzt ist, und andererseits eine Ausgangsbuchse (34) vom Typ Multikontakt, deren Kontakte jeweils ganz oder teilweise mit den elektrischen Leitern (33) des Teststeckers (13) verbunden sind, wobei die Ausgangsbuchse (34) des Teststeckers (13) so konfiguriert ist, dass sie mit einem dritten Verbinder vom Typ Multikontakt verbunden werden kann, der unabhängig vom Prüfblock und vom Teststecker (13) ist, und dessen Kontakte elektrisch mit der Testeinrichtung verbunden sind, insbesondere über ein Mehrleiterkabel.

6. Prüfanlage nach Anspruch 5, **dadurch gekennzeichnet, dass**, während dem der Teststeckers (13) im Aufnahmeraum (12) eingesteckt ist, der durch das Unterteil (10) begrenzt ist, die elektrischen Leiter (33), die mit den Kontakten der Ausgangsbuchse (34) des Teststeckers (13) verbunden sind, elektrisch mit allen oder einem Teil der Kontakte der Ausgangsbuchse (18) des Unterteils (10) des Prüfblocks mittels allen oder einem Teil der internen elektrischen Schaltungen verbunden sind.

7. Prüfanlage nach einem der Ansprüche 5 oder 6, **dadurch gekennzeichnet, dass** die Ausgangsbuchse (34) des Teststeckers (13) durch einen männlichen oder weiblichen Verbinder vom Typ RJ45 gebildet ist, der eine Pinbelegung mit 8 Kontaktpositionen umfasst, wobei jeder der Pins einem Kontakt der Ausgangsbuchse (34) des Teststeckers (13) entspricht.

8. Prüfanlage nach einem der Ansprüche 5 bis 7, **dadurch gekennzeichnet, dass** sie den dritten Verbinder vom Typ Multikontakt umfasst, der unabhängig vom Prüfblock und vom Teststecker (13) ist, und komplementär mit der Ausgangsbuchse (34) des Teststeckers (13), so dass er mit der Ausgangsbuchse (34) des Teststeckers (13) verbunden werden kann, und dessen Kontakte elektrisch mit der Testeinrichtung verbunden sind, insbesondere über ein Mehrleiterkabel, und dadurch, dass die Ausgangsbuchse (34) des Teststeckers (13) und der dritte Verbinder so konfiguriert sind, dass die elektrische Verbindung der elektrischen Leiter (33) des Teststeckers (13) mit der Testeinrichtung aus der Maßnahme der Verbindung des dritten Verbinders mit der Ausgangsbuchse (34) des Teststeckers (13) resultiert.

## Claims

1. A test block intended to be implanted in the circuit connecting an apparatus to be tested such as an electricity meter or a protective relay and a power source supplying the apparatus to be tested such as an intensity sensor and/or a voltage sensor, the test block comprising:
- a base (10) including a plurality of inner electric circuits capable of allowing the transmission of information from the power source to the apparatus to be tested,
- a protective cover (11) intended to be assembled in a dismountable manner with the base (10) in order to form a closed enclosure in which the inner electric circuits are housed,
- the base (10) and the protective cover (11) being configured such that the removal of the protective cover (11) gives access to a receiving site (12) delimited by the base (10) and capable of receiving by plugging a test plug (13) independent of the test block and electrically linked to a test equipment, in particular a voltmeter and/or an ammeter and/or a dummy current source, the base (10) and the protective cover (11) comprise electrically conductive elements linked to each other and configured so as to ensure a continuity,
the test block being **characterized in that** the base (10) comprises:
- at least one multi-contact type input socket (17) accessible from the outside of the enclosure and whose contacts are respectively electrically linked to inner electric circuits so that the input socket (17) is connected to all inner electric circuits at the same time, the input socket (17) being configured so as to be able to be connected to a first multi-contact type connector independent of the test block and whose contacts are electrically connected to the power supply, in particular via a multicore cable,
- and at least one multi-contact type output socket (18) accessible from the outside of the enclosure and whose contacts are respectively electrically linked to the inner electric circuits so that the output socket (18) is connected to all inner electric circuits at the same time, the output socket (18) being configured so as to be able to be connected to a second multi-contact type connector independent of the test block and whose contacts are electrically linked to the apparatus to be tested, in particular via a multicore cable,
**in that** the base (10) and the protective cover (11) comprise electrically conductive elements linked to each other and configured so as to ensure as well a magnetic shielding closure such as the enclosure delimited by the base (10) and the protective cover (11) is a Faraday cage protecting the inner electric circuits relative to the magnetic fields external to the enclosure delimited by the base (10) and the protective cover (11),
and **in that** the base (10) comprises a removable lid (20) whose removal relative to the rest of the base (10) gives access to the inner electric circuits and whose nature and/or shape is adapted to the nature of the input and output sockets (17, 18).

2. A test appliance comprising a test block according to claim 1 and a test plug (13) capable of being plugged into the receiving site (12) delimited by the base (10) after removal of the protective cover (11), the inner electric circuits of the test block and the test plug (13) being configured such that the plugging of the test plug (13) causes a temporary action on all or part of the inner electric circuits of the test block as long as the test plug (13) is plugged, said temporary action being such as it allows carrying out measuring and/or calibrating operations in relation with the apparatus to be tested thanks to the test equipment.

3. The test appliance according to claim 2, **characterized in that** it comprises a first multi-contact type connector independent of the test block and of the test plug (13), complementary to the input socket of the test block so as to be able to be connected to the input socket (17) of the test block and whose contacts are electrically linked to the power source, in particular via a multicore cable, and **in that** the input socket (17) of the test block and the first connector are configured such that the electric connection between the inner electric circuits of the test block and the power source results from the action of connecting the first connector with the input socket (17) of the test block.

4. The test appliance according to any one of claims 2 or 3, **characterized in that** it comprises a second multi-contact type connector independent of the test block and of the test plug (13), complementary to the output socket (18) of the test block so as to be able to be connected to the output socket (18) of the test block and whose contacts are electrically linked to the apparatus to be tested, in particular via a multicore cable, and **in that** the output socket (18) of the test block and the second connector are configured such that the electric connection between the inner electric circuits and the apparatus to be tested results from the action of connecting the second connector with the output socket (18) of the test block.

5. The test appliance according to any of claims 2 to 4, **characterized in that** the test plug (13) comprises, on the one hand, a plurality of actuating elements (32) and a plurality of electric conductors (33) configured so as to act on the inner electric circuits of the base (10) in a manner causing said temporary action as long as the test plug (13) is plugged into the receiving site (12) delimited by the base (10) and, on the other hand, a multi-contact type output socket (34) whose contacts are respectively connected to all or part of the electric conductors (33) of the test plug (13), the output socket (34) of the test plug (13) being configured so as to be able to be connected to a third multi-contact type connector independent of the test block and of the test plug (13) and whose contacts are electrically linked to the test equipment, in particular via a multicore cable.

6. The test appliance according to claim 5, **characterized in that** when the test plug (13) is plugged into the receiving site (12) delimited by the base (10), the electric conductors (33) which are connected to the contacts of the output socket (34) of the test plug (13) are electrically linked to all or part of the contacts of the output socket (18) of the base (10) of the test block via all or part of the inner electric circuits.

7. The test appliance according to any of claims 5 or 6, **characterized in that** the output socket (34) of the test plug (13) is formed by a male or female connector of the RJ45 type comprising a pinning with 8 contact positions, each of the pins corresponding to a contact of the output socket (34) of the test plug (13).

8. The test appliance according to any of claims 5 to 7, **characterized in that** it comprises the third multi-contact type connector independent of the test block and of the test plug (13), complementary to the output socket (34) of the test plug (13) so as to be able to be connected to the output socket (34) of the test plug (13) and whose contacts are electrically linked to the test equipment, in particular via a multicore cable and **in that** the output socket (34) of the test plug (13) and the third connector are configured such that the electric connection of the electric conductors (33) of the test plug (13) to the test equipment results from the action of connecting the third connector in the output socket (34) of the test plug (13).
